# EUROPEAN PATENT APPLICATION

(11) **EP 4 471 878 A1**
(43) Date of publication of application: **04.12.2024**
(21) Application number: 22922741.8
(22) Date of filing: 27.01.2022
(51) Int. Cl.: H01L 31/105, H01L 31/09, H01L 31/18

(54) **INFRARED DETECTOR AND PREPARATION METHOD THEREFOR**

(71) Applicant: Infiray Technology Co., Ltd, Chengdu, Sichuan 610000 (CN)
(72) Inventor: LIU, Lu, Chengdu, Sichuan 610000 (CN); ZHOU, Xun, Chengdu, Sichuan 610000 (CN); ZHAN, Wenhui, Chengdu, Sichuan 610000 (CN)
(74) Representative: Reiser & Partner Patentanwälte mbB
(86) International application number: PCT/CN2022/074382
(87) International publication number: WO 2023/141895

(57) **Abstract**

Provided are an infrared detector and a preparation method therefor. The infrared detector mainly comprises a first contact layer (800), a second contact layer (300), and an absorption layer (400) and a barrier composite layer, which are located between the first contact layer and the second contact layer, wherein the barrier composite layer comprises an intrinsic layer (500), a field control layer (600) and a blocking layer (700), which are sequentially adjacent to each other and are all made of a wide band-gap semiconductor material, and the intrinsic layer is adjacent to the absorption layer, which is made of a narrow band-gap semiconductor material. The doping type of the absorption layer is N-type doping, and the doping types of the field control layer and the blocking layer are both P-type doping, such that the barrier composite layer and the absorption layer can form a PIN structure, and a depletion layer of the infrared detector is transferred into the wide band-gap intrinsic layer, thereby effectively inhibiting a generation-recombination current of the detector.

## Description

### FIELD

The present application relates to the field of semiconductor technology, in particular to an infrared detector and a method for manufacturing same.

### BACKGROUND

Compared with other wavelength detection, short-wave infrared detection not only has the ability to distinguish details similar to visible light reflective imaging, but also has the ability to detect invisible light. It has distinctive and irreplaceable imaging advantages and can be widely used in many fields.

Common short-wave infrared detectors mainly include detectors that are manufactured based on two materials: InGaAs (indium gallium arsenide) and HgCdTe (mercury cadmium telluride). InGaAs detectors perform well at wavelengths below 1.7µm, and with the continuous improvement of material maturity, the performance of InGaAs detectors has been comparable to that of HgCdTe detectors in the spectral range of extended cut-off wavelengths (1.7µm<λc<2.5µm). In addition, the short-wave infrared type-II superlattice (T2SL) technology based on Sb (antimony) compounds has also developed rapidly in recent years, especially for the InP-based InGaAs/GaAsSb (indium gallium arsenic/gallium arsenic antimony) system T2SL, which not only can respond in the spectral band below 2.5µm, but also has a dark current level better than that of HgCdTe detectors at the same working temperature. InGaAs detectors and InP-based T2SL detectors will become the most valuable short-wave infrared detectors based on the comprehensive consideration of performance, cost, manufacturability and other factors.

In the prior art, a PIN structure (a structure having an intrinsic semiconductor layer sandwiched between a P-type semiconductor layer and an N-type semiconductor layer) is usually utilized in InGaAs detectors, but with the application requirements for the extension of the cut-off wavelength, it is necessary to increase the composition of In in the absorption layer. However, as the defects of InGaAs materials with high In composition gradually increase, the dominant mechanism of bulk dark current will change from diffusion to generation-recombination mechanism. In this case, depletion of the absorption layer with a narrow bandgap will cause the dark current of the detector to increase significantly. For InP-based InGaAs/GaAsSb type-II superlattice detectors, suppressing generation-recombination in the absorption layer is also an important way to reduce the level of dark current.

### TECHNICAL PROBLEM

In order to solve the existing technical problems, embodiments of the invention provide an infrared detector and a manufacturing method therefor to reduce the dark current.

### TECHNICAL SOLUTION

In a first aspect, an embodiment of the present invention provides an infrared detector, including a first contact layer, a second contact layer, and an absorption layer and a barrier composite layer between the first contact layer and the second contact layer; the absorption layer is an N-type doped narrow bandgap semiconductor material layer ; the barrier composite layer includes an intrinsic layer, a field control layer and a barrier layer that are adjacent in sequence, wherein the intrinsic layer is adjacent to the absorption layer, and is a wide bandgap semiconductor material layer, and each of the field control layer and the barrier layers is a P-type doped wide bandgap semiconductor material layer.

In a first aspect, the present invention provides a manufacturing method for an infrared detector as described, including: epitaxial growing a second contact layer on a substrate; epitaxial growing an N-type doped narrow bandgap semiconductor material on the second contact layer to form an absorption layer; epitaxial growing an intrinsic layer, a field control layer and a barrier layer in sequence on the absorption layer, to form a barrier composite layer, the intrinsic layer is a wide bandgap semiconductor material layer, and each of the field control layer and the barrier layer is a P-type doped wide bandgap semiconductor material layer; epitaxial growing a first contact layer on the barrier layer.

### BENEFICIAL EFFECTS

In the infrared detector and the manufacturing method therefor that are provided in the above embodiments of the present invention, the infrared detector mainly includes a first contact layer, a second contact layer, and an absorption layer and a barrier composite layer between the first contact layer and the second contact. The barrier composite layer includes an intrinsic layer, a field control layer and a barrier layer which are adjacent in sequence and are all of a wide bandgap semiconductor material, and the intrinsic layer is adjacent to the absorption layer of a narrow bandgap semiconductor material. The doping type of the absorption layer is N-type doping, and the field control layer and the barrier layer are both P-type doping, so that the barrier composite layer and the absorption layer can form a PIN structure, with the depletion layer of the infrared detector transferred into the wide bandgap intrinsic layer, thereby effectively suppressing the generation-recombination current of the detector.

### BRIEF DESCRIPTION OF THE DRAWINGS

FIG. 1 is a schematic diagram of an infrared detector according to some embodiments of the present application;
FIG. 2 is a schematic diagram of an infrared detector according to some embodiments of the present application;
FIG. 3 is a schematic diagram of an infrared detector according to some embodiments of the present application;
FIG. 4 is a schematic diagram of the energy band sequence of an infrared detector according to some embodiments of the present application;
FIG. 5 is a schematic diagram of an infrared detector according to some embodiments of the present application;
FIG. 6 is a schematic diagram of a manufacturing process of an infrared detector according to some embodiments of the present application;
FIG. 7 is a schematic diagram of a manufacturing process of an infrared detector according to some embodiments of the present application;
FIG.8a to FIG.8e are schematic diagrams of intermediate structures formed in the manufacturing process of the infrared detector according to some embodiments of the present application.

### DESCRIPTION OF THE EMBODIMENTS

The technical solution of the present application will be further described in detail below with reference to the accompanying drawings and specific embodiments of the description.

Unless otherwise defined, all technical and scientific terms used herein have the same meaning as commonly understood by those skilled in the art to which the present application pertains. The terminology used in the description of the application is for the purpose of describing specific embodiments only and is not intended to limit the implementation of the application. As used herein, the term "and/or" includes any and all combinations of one or more of the associated listed items.

In the description of the present application, it should be understood that the terms "center", "upper", "lower", "front", "back", "left", "right", "vertical", "horizontal", "top", "bottom", "inner", "outer", etc indicating the orientations or positional relationships are based on the orientations or positional relationships shown in the drawings. They are only for the convenience of describing the present application and simplifying the description, and are not intended to indicate or imply that the devices or elements involved must have a specific orientation, and must be constructed and operated in a specific orientation and, therefore, they are not to be construed as limitations of the application. In the description of the present application, unless otherwise specified, "plurality" means two or more.

In the process of research, the inventors of the present application found that short-wave infrared detectors utilizing the extended-wavelength of the conventional PIN structure have the above-mentioned problems, and also found that, when a nBn unipolar barrier structure is used to solve the dark current problem of the InGaAs detector and the InP-based T2SL detector, due to the restriction of the energy band type and concentration level of the intrinsic background of the barrier layer, it can be difficult to form an ideal unipolar barrier, and the effect of reducing the dark current is not obvious. Therefore, the inventors of the present application provide a new infrared detection structure, which can be applied to short-wave infrared detection, especially suitable for InGaAs detectors with extended cut-off wavelengths or InP-based InGaAs/GaAsSb type-II superlattice detectors. Of course, the infrared detector provided by the present invention can also be applied to detectors of other wavelength types on the basis of selecting suitable materials.

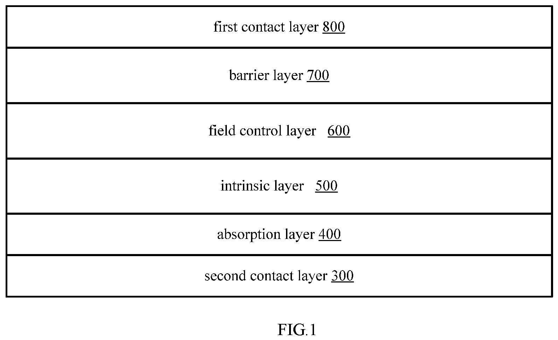

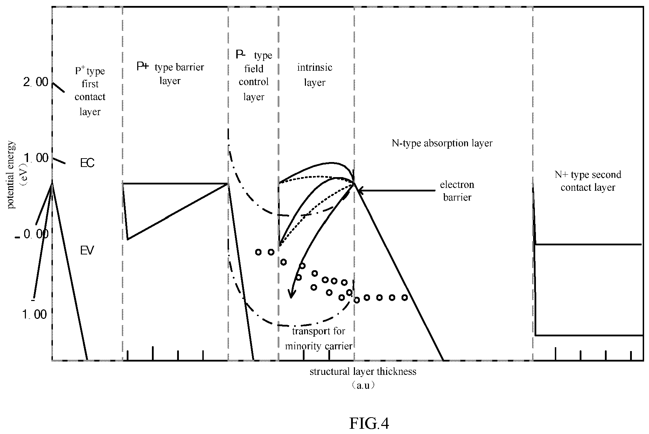

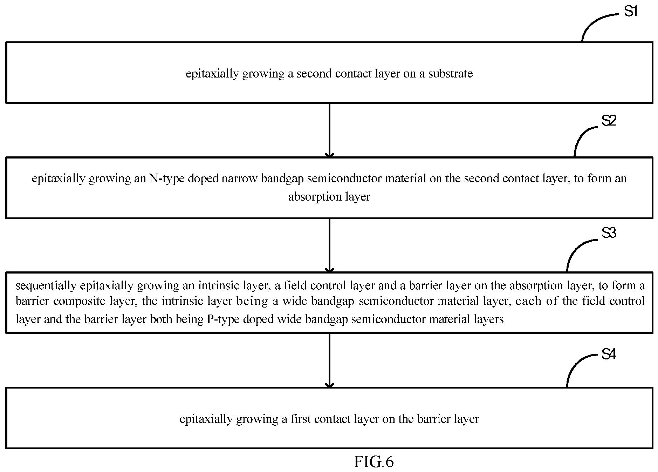

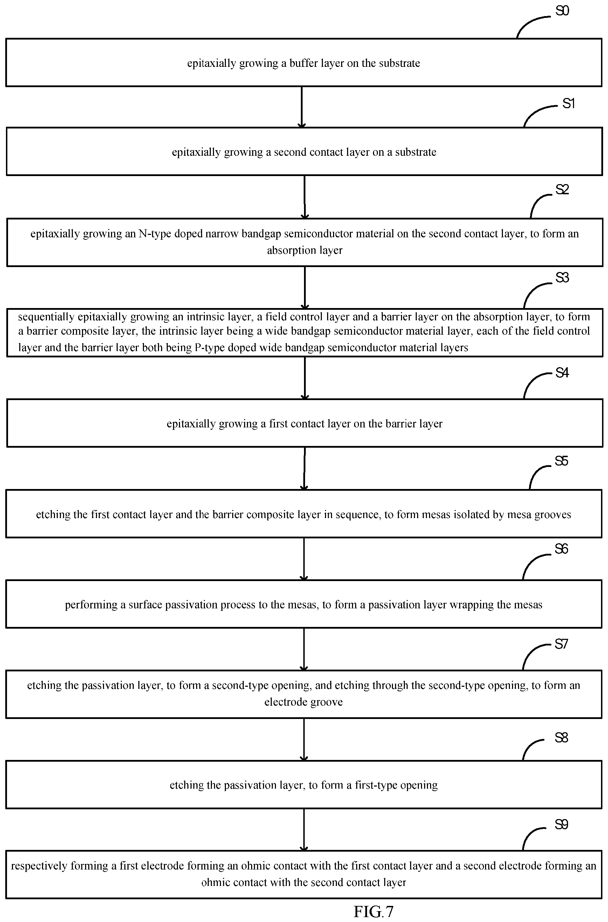

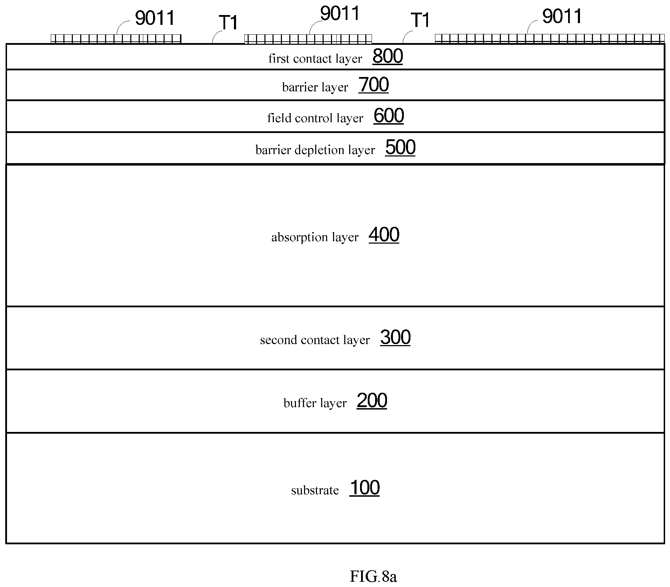

FIG. 1 to FIG. 3 and FIG. 5 show schematic diagrams of infrared detectors according to different embodiments of the present application, and FIG. 4 is a schematic diagram of the energy band sequence of a structure of the infrared detector according to the present application, FIG. 6 and FIG. 7 are the schematic diagrams of the manufacturing process of the infrared detector according to different embodiments of the present application, and FIG. 8a to FIG. 8e are schematic diagrams of intermediate structures formed in the manufacturing process of the infrared detection device according to some embodiments of the present application. The infrared detector provided by the present application and its manufacturing method will be described in detail below with reference to the above figures.

Referring to FIG. 1, in some embodiments, an infrared detector includes a first contact layer 800, a second contact layer 300, and an absorption layer 400 and a barrier composite layer between the first contact layer 800 and the second contact layer 300. The barrier composite layer includes an intrinsic layer 500, a field control layer 600 and a barrier layer 700 that are adjacent in sequence.

The intrinsic layer 500 is adjacent to the absorption layer 400, that is, the intrinsic layer 500 is arranged on a first side of the absorption layer 400, and is of a wide bandgap semiconductor material, that is, its band gap is at least larger than that of the incident energy.

The field control layer 600 is arranged on a side of the intrinsic layer 500 facing away from the absorption layer 400. The intrinsic layer 500 has a first side and a second side which are opposite to each other, the second side of the intrinsic layer 500 is in contact with the first side of the absorption layer 400, and the first side of the intrinsic layer 500 is adjacent to the field control layer 600. The field control layer 600 has an opposite doping type to that of the absorption layer 400, and the field control layer 600 is mainly used to prevent the accumulation of minority carriers in the absorption layer 400 at the interface between the absorption layer 400 and the intrinsic layer 500, that is, the field control layer 600 is used to eliminate or reduce the minority carrier barrier that exists at the interface between the absorption layer 400 and the intrinsic layer 500 and that blocks or impedes the transport of minority carriers in the absorption layer 400, so as to avoid the minority carriers in the absorption layer 400 from accumulating near the interface between the absorption layer 400 and the intrinsic layer 500.

The barrier layer 700 has the same doping type as the field control layer 600, and its doping concentration is greater than the doping concentration of the field control layer 600, that is, the barrier layer 700 is heavily doped relative to the field control layer 600, and the field control layer 600 is lightly doped. The doping type of the absorption layer 400 is N-type doping, and the doping type of the field control layer 600 and the barrier layer 700 is P-type doping. The barrier layer 700 is utilized to reduce the surface dark current of the detector, which requires the selection of a wide bandgap material.

It should be noted that, photons in the incident light of the infrared detector are absorbed by the absorption layer 400 after entering the absorption layer 400, thereby generating photo-generated carriers. Therefore, the band gap of the absorption layer 400 is less than or equal to the energy of incident photons. The absorption layer 400 is a narrow bandgap semiconductor layer relative to the intrinsic layer 500, and the intrinsic layer 500 is a wide bandgap semiconductor layer relative to the absorption layer 400. That is, the absorption layer 400 is a narrow bandgap semiconductor material layer, but each of the intrinsic layer 500, the field control layer 600 and the barrier layer 700 is a wide bandgap semiconductor material layer. In addition, the majority carriers in the present application refer to one of electrons and electron holes, and the minority carriers refer to the other of electrons and electron holes. For example, for an N-type doped absorption layer, the majority carriers are electrons, and the minority carriers are electron holes, but for a P-type doped absorption layer, the majority carriers are electron holes, and the minority carriers are electrons.

The doping types of the absorption layer 400 and the field control layer 600 arranged on opposite sides of the intrinsic layer 500 are different, and the doping type of the barrier layer 700 is the same as that of the field control layer. As a result, the barrier layer, the field control layer 600, the intrinsic layer 500 and the absorption layer 400 form a PIN structure, and as can be known based on the principle of the PIN structure, a depletion layer of the structure is arranged in the intermediate intrinsic layer 500. Since the band gap of the intrinsic layer 500 is greater than the energy of the incident photons, the intrinsic layer 500 is a wide bandgap material relative to the absorption layer 400, so it can effectively reduce the generation-recombination current of the infrared detector, that is, to reduce the dark current of the detector. The reason is that the generation-recombination mechanism mainly occurs in the depletion layer (space charge layer), the generation-recombination current in the depletion layer is proportional to the concentration of intrinsic carriers, and the concentration of intrinsic carriers is inversely proportional to the band gap, so in this application, through the PIN structure formed by the barrier composite layer and the absorption layer 400, the depletion layer can be entirely transferred to the wide bandgap intrinsic layer 500, thereby reducing the generation-recombination current. The field control layer adjacent to the intrinsic layer 500 is configured to be lightly doped, and the doping process has almost no adverse effect on the intrinsic layer, and it is also used to eliminate the minority carrier barrier formed at the interface between the intrinsic layer 500 and the absorption layer 400, preventing the accumulation of minority carriers at the interface between the intrinsic layer 500 and the absorption layer 400, thus facilitating improving the transport of minority carriers in the absorption layer 400. Therefore, the field control layer 600 can improve the barrier width of the depletion layer in the intrinsic layer 500 at a side of the intrinsic layer 500 close to the barrier layer 700, thereby reducing the probability of tunnel breakdown. Since the barrier layer 700 is far away from the intrinsic layer 500 relative to the field control layer 600, it can be heavily doped relative to the field control layer 600, which can thus effectively suppress leakage on the surface of the first contact layer 800.

In the infrared detector provided in the present application, the doping type of the absorption layer 400 is N-type doping, and the doping types of the field control layer 600 and the barrier layer 700 are both P-type doping. Then the infrared detector provided in the present application is a P-Bp-B2-N type infrared detector, where P in P-Bp-B2-N refers to the P-type doped first contact layer 800, and Bp in P-Bp-B2-N refers to the P-type doped barrier layer 700, B2 refers to the double-barrier layer composed of the field control layer 600 and the intrinsic layer 500, Bp-B2 in P-Bp-B2-N is the barrier composite layer provided in this application, and N in P-Bp-B2-N refers to the N-type doped absorption layer 400. Therefore, in this embodiment, the majority carriers in the absorption layer 400 are electrons, and the minority carriers are electron holes. Since the barrier composite layer Bp-B2 includes an intrinsic layer adjacent to the absorption layer 400 and includes a field control layer 600 and a barrier layer 700 of a doping type opposite to the absorption layer 400, the structure P-Bp-B2-N has the function of the PIN structure, that is, the depletion layer is entirely arranged in the intrinsic layer 500. At the same time, because the barrier composite layer Bp-B2 is an electron barrier layer in the absorption layer 400, the P-Bp-B2-N type infrared detector also has the function of a PBN unipolar barrier structure (with an electron barrier B layer arranged between the P-type contact layer and the N-type absorption layer).

As can be seen from the above, the infrared detector provided in the present application mainly includes a first contact layer, a second contact layer, and an absorption layer and a barrier composite layer arranged between the first contact layer and the second contact layer. The barrier composite layer includes an intrinsic layer, a field control layer and a barrier layer which are adjacent in sequence and are all of wide bandgap semiconductor materials, and the intrinsic layer is adjacent to the absorption layer of narrow bandgap semiconductor material. The doping type of the absorption layer is N-type doping, and the field control layer and the barrier layer are both P-type doping, so that the barrier composite layer and the absorption layer can form a PIN structure, with the depletion layer of the infrared detector transferred into the wide bandgap intrinsic layer, thus effectively suppressing the generation-recombination current in the detector, i.e. the dark current of the infrared detector. In addition, since the field control layer 600 can effectively prevent the minority carriers in the absorption layer 400 from accumulating in the intrinsic layer 500 and, at the same time, can regulate the charge distribution in the intrinsic layer 500, the detection performance of the infrared detector can be further improved.

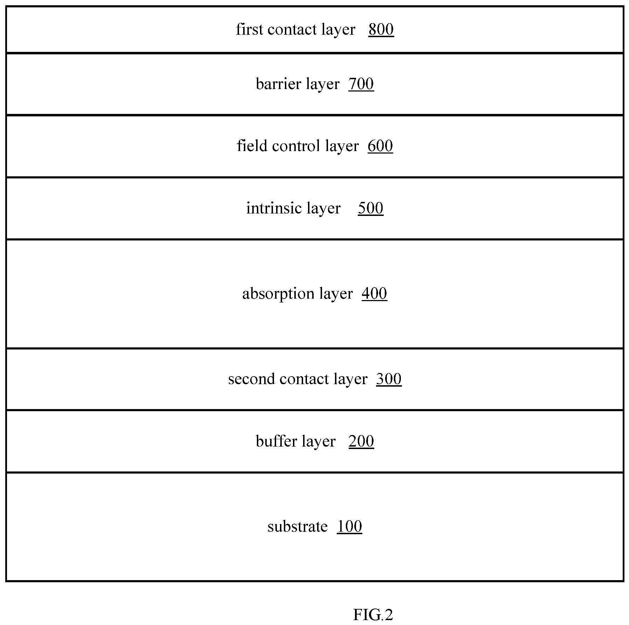

In some embodiments, as shown in FIG. 2, the infrared detector provided according to the present application further includes a substrate 100 and a buffer layer 200. The buffer layer 200 is arranged between the substrate 100 and the second contact layer 300; specifically, the buffer layer 200 is arranged on one side of the substrate 100. For example, the substrate 100 includes a first side and a second side which are opposite to each other, a second side of the buffer layer 200 is in contact with the first side of the substrate 100, and a side of the buffer layer 200 away from the first side of the substrate 100 is a second side. The second contact layer 300 is arranged on the side of the buffer layer 200 away from the substrate 100, that is, the second side of the buffer layer 200 is in contact with the second contact layer 300.

The doping type of the second contact layer 300 is the same as that of the absorption layer 400, and the doping concentration of the second contact layer 300 is greater than that of the absorption layer 400. Therefore, the second contact layer 300 is a heavily doped semiconductor layer relative to the absorption layer 400, while the absorption layer 400 is a lightly doped semiconductor layer. In addition, in some embodiments, the second side of the substrate 100 is an incident side for incident photons, that is, the corresponding infrared detector is a back-illuminated infrared detector; to avoid the incident photons from being absorbed by other semiconductor layers before being incident on the absorption layer 400, the band gap of each of the buffer layer 200 and the second contact layer 300 needs to be greater than the energy of the incident photons, that is, each of the buffer layer 200 and the second contact layer 300 is a wide bandgap semiconductor material layer; in addition, the substrate 100 is also of a wide bandgap semiconductor material, and a band gap of the substrate 100 is also greater than the energy of the incident photons.

FIG. 4 is a schematic diagram of the energy band sequence of the first contact layer 800, the barrier composite layer, the absorption layer and the second contact layer in the P-Bp-B2-N infrared detector provided in the present application. The vertical ordinate in FIG. 4 is the potential energy of the valence band maximum EV and the conduction band minimum EC, and the horizontal coordinate is the thickness of each functional layer of the P-Bp-B2-N infrared detector.

As shown in FIG. 4, in some embodiments, the energy of the conduction band minimum of the intrinsic layer 500, the energy of the conduction band minimum of the field control layer 600, and the energy of the conduction band minimum of the barrier layer 700 sequentially increase. That is, the difference between the energy of the conduction band minimum of the intrinsic layer 500 and the energy of the conduction band minimum of the absorption layer 400, the difference between the energy of the conduction band minimum of the field control layer 600 and the energy of the conduction band minimum of the absorption layer 400, and the difference between the energy of the conduction band minimum of the barrier layer 700 and the energy of the conduction band minimum of the absorption layer 400 increase sequentially, and the function of each functional layer of the barrier composite layer can be optimized respectively. Therefore, in some embodiments, the band gap of the barrier layer 700 is greater than the band gap of each of the field control layer 600 and the band gap of the intrinsic layer 500. Compared with the absorption layer 400, the intrinsic layer 500 and the barrier layer 600 are both of wide bandgap materials, that is, the band gap of each of the intrinsic layer 500 and the barrier layer 600 is greater than the energy of incident photons.

In addition, in the embodiment of the present application, as shown in FIG. 4, the minority carriers in the absorption layer 400 are transported to the first contact layer 800 through the valance band maximums of the intrinsic layer 500, the field control layer 600, and the barrier layer 700 in sequence. Because the field control layer 600 can regulate the electric field in the intrinsic layer 500 to increase the lowest energy of the valance band maximum of the intrinsic layer 500 relative to the energy of the valence band minimum of the absorption layer 400, the accumulation of the minority carriers at the interface between the absorption layer 400 and the intrinsic layer 500 can be eliminated, so that the minority carriers in the absorption layer 400 can be smoothly transported to the first contact layer 800 through the valance band maximum of each layer.

Further, in some embodiments, the first contact layer 800 is a narrow bandgap semiconductor material layer. For example, the band gap of the first contact layer 800 is less than the band gap of the intrinsic layer 500, that is, the first contact layer 800 is a narrow bandgap semiconductor material layer relative to the intrinsic layer 500.

In some embodiments, in order to further optimize the performance of the infrared detector provided in the present application, the thickness of the barrier layer 700 can be configured to be greater than or equal to the thickness of the intrinsic layer 500, and the thickness of the intrinsic layer 500 can be configured to be greater than or equal to the thickness of the field control layer 600. However, it should be noted that, in other embodiments, the relationship between the thicknesses of the barrier layer 700, the field control layer 600, and the intrinsic layer 500 is not limited, and can be adjusted according to actual application requirements.

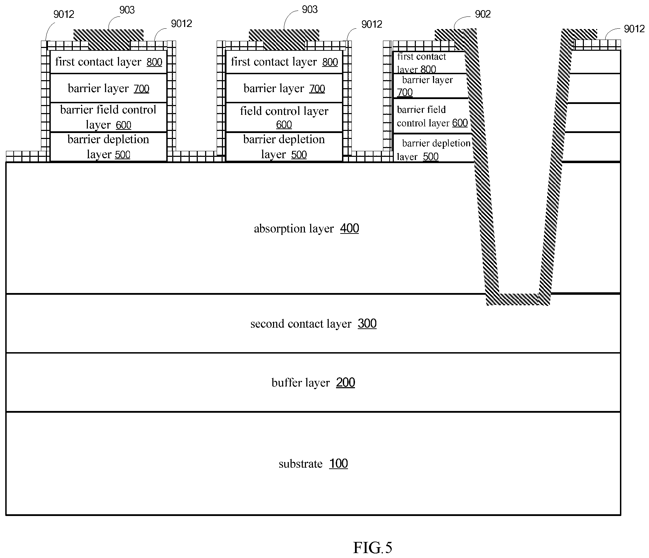

Referring to FIG. 4, the dash-dotted line in the field control layer and the intrinsic layer indicates an energy band of the intrinsic layer corresponding to the structure of the barrier composite layer only including the barrier layer and the intrinsic layer but not including the field control layer, which obviously is more concave than the energy band (solid line) of the intrinsic layer when there is a field control layer, and this causes the minority carriers in the absorption layer to be accumulated in this concave, which is not conducive to the transport of the minority carrier. In addition, if the field control layer is not added, in the case of a reverse bias, the side of the intrinsic layer close to the barrier layer is also prone to tunnel breakdown. FIG. 4 also shows an energy band structure of the intrinsic layer when the P-Bp-B2-N infrared detector provided in the present application is reversely biased, as indicated by another non-dotted dash line in FIG. 5.

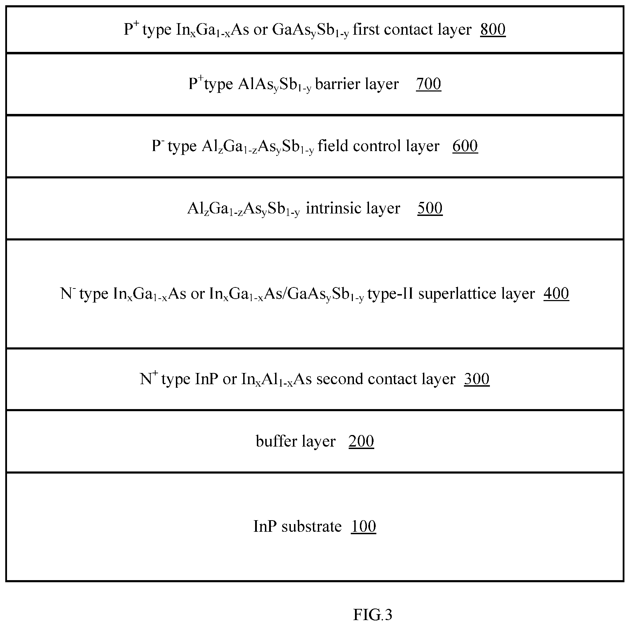

As shown in FIG. 3, in some embodiments, in a direction from the substrate to the first contact layer, the infrared detector provided in the present application sequentially includes an InP substrate 100, a wide bandgap buffer layer 200, an N⁺ type second contact layer 300, an N⁻type absorption layer 400, a wide bandgap intrinsic layer 500, a P⁻ type field control layer 600, a P⁺ type barrier layer 700, and a P⁺ type first contact layer 800. In this application, N⁻ represents light doping relative to N⁺ , N⁺ represents heavy doping relative to N⁻, P⁻ represents light doping relative to P⁺, and P⁺ represents heavy doping relative to P⁻.

The P-Bp-B2-N infrared detector provided in this application is suitable for InGaAs short-wave infrared detectors or InGaAs/GaAsSb type-II superlattice short-wave infrared detectors, and is particularly suitable for extended wavelength InGaAs short-wave infrared detectors or InGaAs/ In GaAsSb type-II superlattice short-wave infrared detectors, i.e. where the composition of In in the absorption layer is relatively high.

In some embodiments, each of the intrinsic layer 500 and the field control layer 600 is a wide bandgap antimony (Sb) compound semiconductor material layer, and the antimony component in the intrinsic layer matches the lattice of the absorption layer.

Specifically, in some embodiments, the absorption layer 400 is an InₓGa₁₋ₓAs layer, where 0.47≤x≤0.82. The absorption layer 400 is an N⁻ absorption layer lightly doped with N-type Si (silicon) or S (sulfur), the doped donor concentration is 0.5-5E+17cm⁻³, and the thickness of the N⁻ type InₓGa₁₋ₓAs absorption layer is 2.0-3.0µm.

In some embodiments, the absorption layer 400 is a In_{0.53}Ga_{0.47}As/GaAs_{y}Sb_{1-y} type-II superlattice layer, wherein the thickness of the In_{0.53}Ga_{0.47}As well layer is 4-7 nm, and the thickness of the GaAs_{y}Sb_{1-y} barrier layer is 4-7nm, the range of composition y is: 0.47≤y≤0.51, and the period number is 150-300.

In some embodiments, each of the intrinsic layer 500 and the field control layer 600 is a Sb compound semiconductor layer with a band gap greater than a predetermined value, that is, the intrinsic layer is a wide bandgap semiconductor layer containing Sb.

Specifically, the intrinsic layer 500 is an Al_{z}Ga_{1-z}As_{y}Sb_{1-y} layer, wherein the range of the composition z of the Al is: 0.2≤z≤0.5, and the thickness of the intrinsic layer 500 is 0.3-1.0µm, and its background carrier concentration is 1-10E+15cm⁻³. When the absorption layer is the above-mentioned InₓGa₁₋ₓAs layer, the component Sb in the intrinsic layer 500 is adjusted to a preset composition, so that it matches lattices of the absorption layer, that is, to ensure that the lattice mismatch rate between the intrinsic layer and the absorption layer is lower than the allowable maximum mismatch rate.

Specifically, in some embodiments, the field control layer 600 is a lightly doped p⁻type Al_{z}Ga_{1-z}As_{y}Sb_{1-y} layer, the composition of the field control layer 600 is the same as that of an N⁻ type Al_{z}Ga_{1-z}As_{y}Sb_{1-y} intrinsic layer, the thickness of the field control layer 600 is 0.2-0.8µm, and the doped acceptor concentration is 0.5-5E+17cm⁻³. In other embodiments, the field control layer may also be a wide bandgap InP layer.

In some embodiments, the barrier layer 700 is at least one of an AlAsSb layer, an InAlAs layer, an InP layer, and an InAsP layer. Specifically, in this embodiment, the barrier layer 700 is a P⁺ type AlAs_{y}Sb_{1-y} layer, the thickness of the barrier layer 700 is 0.5-2.0µm, and the doped acceptor concentration is 0.5-2E+18cm⁻³

With continued reference to FIG. 5, specifically, in some embodiments, the first contact layer is a P⁺ type InₓGa₁₋ₓAs layer or a GaAs_{y}Sb_{1-y} layer, and the range of the composition y is 0.47≤ y≤0.51, a doped acceptor concentration of the first contact layer is greater or equal to 2E+18cm⁻³, and a thickness of the first contact layer is 0.05-0.2µm. The second contact layer 300 is an N⁺ type wide bandgap InP layer or InAlAs layer, and is heavily doped with Si or S, a doped donor concentration of the second contact layer 300 is 2-8E+18cm⁻³, and a thickness of the second contact layer 300 is 0.2-1.0µm. In addition, the substrate 100 is a single crystal N-type or semi-insulating InP substrate. The buffer layer 200 is a wide bandgap semiconductor material layer , for example, it may be selected from at least one of an InAsP layer, an InP layer, and an InAlAs layer.

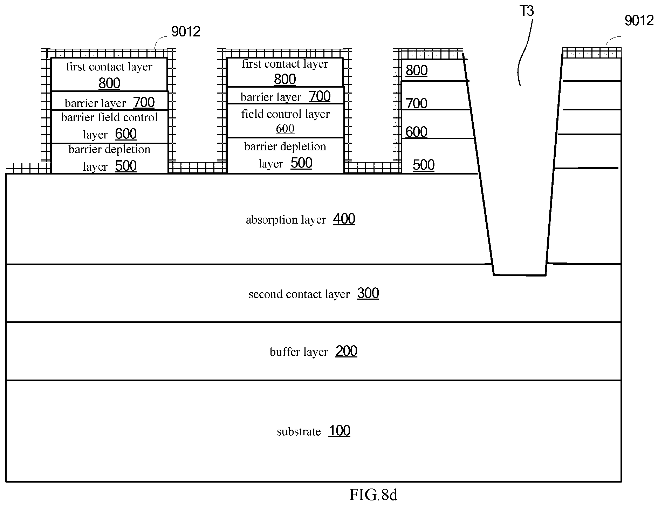

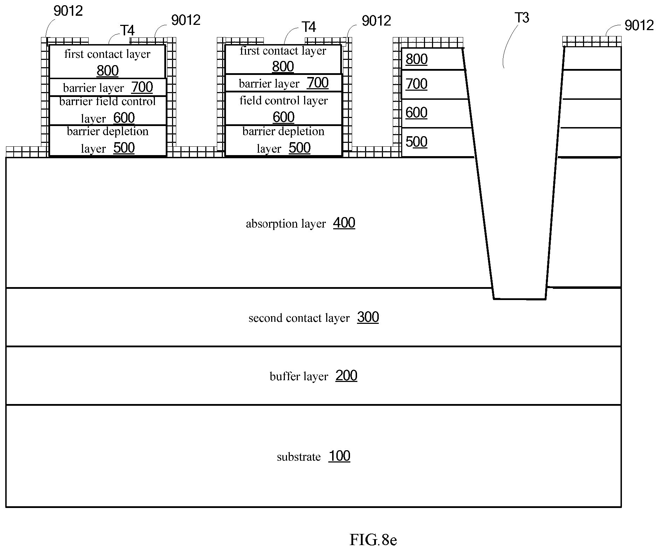

As shown in FIG. 5, in some embodiments, the infrared detector provided according to the present application further includes a passivation layer 9012, a first electrode 903, and a second electrode 902. A portion of the passivation layer 9012 is arranged on a side of the first contact layer 800 facing away from the barrier layer 700, and has a first-type opening (such as T4 in FIG. 8e) and a second-type opening (such as T3 in FIG. 8d). The first-type opening exposes the first contact layer 800, and the second-type opening exposes an electrode groove (deep groove on the right in FIG. 8e) which passes through the first contact layer 800, the barrier composite layer, and the absorption layer 400 in sequence and stops at the second contact layer 300. The first electrode 903 extends through the first-type opening to form an ohmic contact with the first contact layer 800; the second electrode 902 extends through the electrode groove to form an ohmic contact with the second contact layer 300. The passivation layer is selected from at least one of SiNₓ, Al₂O₃, and SiO₂, and each of the first electrode and the second electrode is a Cr/Au or Ti/Pt/Au multilayer metal electrode.

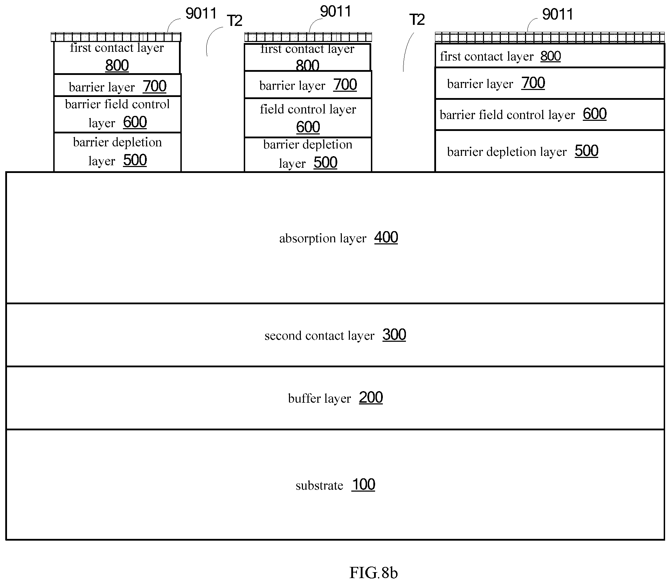

With continued reference to FIG. 5, in some embodiments, the first contact layer 800 and the barrier composite layer are divided into a plurality of mesas arranged on the absorption layer 400 by mesa grooves (T2 in FIG. 8b ), and the mesa grooves extend from a surface of the first contact layer 800 to a surface of the absorption layer 400, and the passivation layer 9012 extends from a side of the first contact layer 800 facing away from the barrier layer 700 to a sidewall and a bottom of the mesa grooves, thereby wrapping exposed portions of the mesas and exposing only the first electrode and the second electrode.

As seen above, the infrared detectors provided in the present application can have the following beneficial effects:
1. By utilizing wide bandgap Sb compounds as barriers, and utilizing double-Sb compounds in the intrinsic layer and the field control layer as barriers, the depletion region can be transferred from the narrow bandgap absorption layer to the wide bandgap barrier region, such that the absorption layer can be dominated by the diffusion mechanism, thereby greatly reducing the bulk generation-recombination dark current.
2. By arranging the field control layer in the barrier composite layer, the degree of freedom of structure modulation is improved, which not only can improve the collection efficiency of the carriers, but also can effectively control the tunnel breakdown dark current of the intrinsic layer as the depletion region.
3. The design of the wide bandgap barrier composite layer can effectively suppress the surface dark current.

In addition, the present application also provides a method for manufacturing an infrared detector according to an embodiment of the present application, and the schematic flowchart of the manufacturing method is shown in FIG. 6. In this embodiment, the manufacturing method includes S1, S2, S3 and S4.
S1: epitaxially growing a second contact layer on a substrate.
S2: epitaxially growing an N-type doped narrow bandgap semiconductor material on the second contact layer, to form an absorption layer.
S3: sequentially epitaxially growing an intrinsic layer, a field control layer and a barrier layer on the absorption layer, to form a barrier composite layer, the intrinsic layer being a wide bandgap semiconductor material layer, each of the field control layer and the barrier layer being a P-type doped wide bandgap semiconductor material layer.
S4: epitaxially growing a first contact layer on the barrier layer.

FIG. 7 is a schematic flowchart of a method for manufacturing an infrared detector according to another embodiment of the present application, and the intermediate structures formed in respective steps are shown in FIGS. 8a-8e. In this embodiment, different from FIG. 6, before S1, the manufacturing method further includes S0: epitaxially growing a buffer layer on the substrate. Then in this embodiment, S1 specifically includes: epitaxially growing the second contact layer on the buffer layer of the substrate.

Specifically, MOCVD (Metal-organic Chemical Vapor Deposition) or MBE (Molecular beam epitaxy) technology is utilized to sequentially epitaxially grow each functional layer on an N-type or semi-insulating InP single crystal substrate. That is, the buffer layer, the second contact layer, the absorption layer, the barrier composite layer and the second contact layer are sequentially epitaxially grown on the substrate, resulting in a structure shown in FIG. 2.

In addition, with continued reference to FIG. 7, in this embodiment, in addition to S0 and S1 to S4 in FIG. 6, the manufacturing method further includes S5 to S9 performed after S4, and the various steps are specifically as follows:
S5: etching the first contact layer and the barrier composite layer in sequence, to form mesas isolated by mesa grooves.

Specifically, as shown in FIG. 8a, an etching mask layer 9011 is firstly formed on the surface of the first contact layer 800, for example, an etching mask layer 9011 with openings T1 is made by utilizing a photoresist or a SiO₂, SiNₓ dielectric film, the openings T1 exposing areas where the mesa grooves are to be arranged. The first contact layer 800 and the barrier composite layer (the barrier layer 700, the field control layer 600, the intrinsic layer 500) in the areas where the mesa grooves are to be arranged are sequentially etched away by wet or dry etching, and the etching stops at the surface of the absorbing layer 400, thereby forming the mesa grooves T2 as shown in FIG. 8b, so that the first contact layer 800 formed at S4 and the barrier composite layer are divided into a plurality of mesas arranged on the surface of the absorption layer 400 and isolated by the mesa grooves T2.

S6: performing a surface passivation process to the mesas, to form a passivation layer wrapping the mesas.

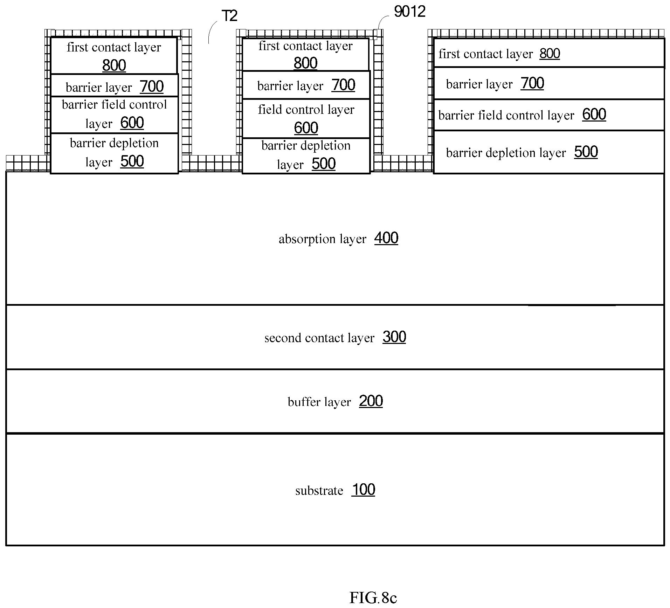

As shown in FIG. 8c, a SiNₓ or Al₂O₃ , SiO₂ dielectric film is deposited on the surface of the intermediate structure of the infrared detector with the mesas formed, to form a passivation layer 9012 that wraps the mesas, and the passivation layer also covers the absorption layer 400 exposed by the mesa groove T2, thereby protecting the surface of the intermediate structure of the infrared detector from being oxidized.

S7: etching the passivation layer to form a second-type opening, and etching through the second-type opening to form an electrode groove.

As shown in FIG.8d, the second-type opening T3 is formed in the passivation layer 9012 formed at S3 by utilizing a wet or dry etching process, so that the second-type opening exposes an area where the second electrode 902 needs to be formed. An etching process is then performed in the area, sequentially etching away the first contact layer 800, the barrier composite layer, and the absorption layer 400 corresponding to the region, and the etching process stops at the second contact layer 300, to form the electrode groove.

S8: etching the passivation layer, to form a first-type opening.

As shown in FIG. 8e, the first-type opening T4 is formed in the passivation layer 9012 by way of photolithography and wet or dry etching, so as to expose the area where the first electrode 903 needs to be formed.

S9: respectively forming a first electrode forming an ohmic contact with the first contact layer and a second electrode forming an ohmic contact with the second contact layer.

The first electrode 903 and the second electrode 902 for the metal semiconductor ohmic contact are made of a Cr/Au or Ti/Pt/Au multilayer metal, thereby forming the infrared detector as shown in FIG. 5.

The above are only specific implementations of the application, but the scope of protection of the application is not limited thereto. Any person familiar with the technical field can easily think of changes or substitutions within the technical scope disclosed in the application, which should be all covered within the scope of protection of this application. Therefore, the protection scope of the present application should be determined by the protection scope of the claims.

## Claims

1. An infrared detector, **characterized by**: comprising a first contact layer, a second contact layer, and an absorption layer and a barrier composite layer arranged between the first contact layer and the second contact layer;
wherein the absorption layer is an N-type doped narrow bandgap semiconductor material layer;
the barrier composite layer comprises an intrinsic layer, a field control layer and a barrier layer that are adjacent in sequence, the intrinsic layer is adjacent to the absorption layer, and is a wide bandgap semiconductor material layer, and each of the field control layer and the barrier layers is a P-type doped wide bandgap semiconductor material layer.

2. The infrared detector according to claim 1, **characterized by**, further comprising a substrate and a buffer layer;
wherein the substrate is an N-type doped InP substrate or a semi-insulating InP substrate;
the buffer layer is a wide bandgap semiconductor material layer;
the buffer layer is arranged between the second contact layer and the substrate, and the absorption layer is arranged on a side of the second contact layer away from the buffer layer.

3. The infrared detector according to claim 2, **characterized in that**, the first contact layer is adjacent to the barrier layer and is a P-type doped narrow bandgap semiconductor material layer;
the second contact layer is adjacent to the absorption layer and is an N-type doped wide bandgap semiconductor material layer, and a doping concentration of the second contact layer is greater than that of the absorption layer.

4. The infrared detector according to claim 3, **characterized in that**, an energy of a conduction band minimum of the intrinsic layer, an energy of a conduction band minimum of the field control layer, and an energy of a conduction band minimum of the barrier layer sequentially increase;
a band gap of the barrier layer is greater than a band gap of the field control layer, and the band gap of the field control layer is greater than or equal to a band gap of the intrinsic layer.

5. The infrared detector according to claim 1, **characterized in that**, the absorption layer is an InGaAs layer or an InGaAs/GaAsSb type II superlattice layer.

6. The infrared detector according to claim 5, **characterized in that**, both the intrinsic layer and the field control layer are wide bandgap antimony compound semiconductor material layers, and the antimony component in the intrinsic layer matches the lattice of the absorption layer.

7. The infrared detector according to claim 6, **characterized in that**, the intrinsic layer is an AlGaAsSb layer;
the field control layer is an AlGaAsSb layer or an InP layer;
the barrier layer is at least one of an AlAsSb layer, an InAlAs layer, an InP layer, and an InAsP layer;
the first contact layer is an InGaAs layer or a GaAsSb layer;
the second contact layer is an InP layer or an InAlAs layer.

8. The infrared detector according to claim 7, **characterized in that**, the first contact layer is an InₓGa₁₋ₓAs layer or a GaAs_{y}Sb_{1-y} layer, and a doped acceptor concentration of the first contact layer is greater or equal to 2E+18cm⁻³, and a thickness of the first contact layer is 0.05-0.2µm;
the absorption layer is an InₓGa₁₋ₓAs layer doped with silicon or sulfur, the thickness of the InₓGa₁₋ₓAs layer is 2.0-3.0µm; or the absorption layer is a In_{0.53}Ga_{0.47}As/GaAs_{y}Sb_{1-y} type-II superlattice layer, wherein a thickness of the In_{0.53}Ga_{0.47}As well layer is 4-7 nm, a thickness of the GaAs_{y}Sb_{1-y} barrier layer is 4-7nm, and the period number of the In_{0.53}Ga_{0.47}As/GaAs_{y}Sb_{1-y} type-II superlattice layer is 150-300;
each of the intrinsic layer and the field control layer is an Al_{z}Ga_{1-z}As_{y}Sb_{1-y} layer, a thickness of the intrinsic layer is 0.3-1.0µm, and a background carrier concentration of the intrinsic layer is 1-10E+15cm⁻³, a thickness of the field control layer is 0.2-0.8µm, and a doped acceptor concentration of the field control layer is 0.5-5E+17cm⁻³;
the barrier layer is an AlAs_{y}Sb_{1-y} layer, a doped acceptor concentration of the barrier layer is 0.5-2E+18cm⁻³ and a thickness of the barrier layer is 0.5-2.0µm;
the second contact layer is an InP layer or InAlAs layer doped with silicon or sulfur, a doped donor concentration of the second contact layer is 2-8E+18cm⁻³, and a thickness of the second contact layer is 0.2-1.0µm;
the ranges of x, y, z are respectively: 0.47≤x≤0.82, 0.47≤y≤0.51, 0.2≤z≤0.5.

9. The infrared detector according to any one of claims 1 to 8, **characterized by**, further comprising a passivation layer, a first electrode, and a second electrode;
wherein at least a portion of the passivation layer is arranged on a side of the first contact layer facing away from the barrier layer, and has a first-type opening and a second-type opening;
the first-type opening exposes the first contact layer, and the second-type opening exposes an electrode groove which passes through the first contact layer, the barrier composite layer, and the absorption layer in sequence and stops at the second contact layer;
the first electrode passes the first-type opening to form an ohmic contact with the first contact layer;
the second electrode passes the electrode groove to form an ohmic contact with the second contact layer.

10. The infrared detector according to claim 9, **characterized in that**, the first contact layer and the barrier composite layer are divided into a plurality of mesas arranged on the absorption layer by mesa grooves, and the mesa grooves extend from a surface of the first contact layer to a surface of the absorption layer;
the passivation layer extends from a side of the first contact layer facing away from the barrier layer to a sidewall and a bottom of the mesa grooves.

11. A manufacturing method for an infrared detector according to claim 1, **characterized in that**, comprises:
epitaxially growing a second contact layer on a substrate;
epitaxially growing an N-type doped narrow bandgap semiconductor material on the second contact to form an absorption layer;
sequentially epitaxially growing an intrinsic layer, a field control layer and a barrier layer on the absorption layer to form a barrier composite layer, wherein the intrinsic layer is a wide bandgap semiconductor material layer, each of the field control layer and the barrier layer is a P-type doped wide bandgap semiconductor material layer;
epitaxially growing a first contact layer on the barrier layer.

12. The manufacturing method according to claim 11, **characterized in that**, before epitaxially growing the second contact layer on the substrate, the manufacturing method further comprises:
epitaxially growing a buffer layer on the substrate;
epitaxially growing the second contact layer on the substrate comprises:
epitaxially growing the second contact layer on the buffer layer on the substrate;
after epitaxially growing the first contact layer on the barrier layer, the manufacturing method further comprises:
etching the first contact layer and the barrier composite layer, to form mesas isolated apart by mesa grooves;
performing a surface passivation process to the mesas, to form a passivation layer wrapping the mesas;
etching the passivation layer, to form a second-type opening, and etching through the second-type opening to form an electrode groove;
etching the passivation layer to form a first-type opening;
respectively forming a first electrode that forms an ohmic contact with the first contact layer and a second electrode that forms an ohmic contact with the second contact layer.
